# EUROPEAN PATENT APPLICATION

(11) **EP 3 399 605 A1**
(43) Date of publication of application: **07.11.2018**
(21) Application number: 17305508.8
(22) Date of filing: 05.05.2017
(51) Int. Cl.: H01S 5/026, H01S 5/14, H01S 5/40, H01S 3/1055, H01S 3/106

(54) **HIGH SPEED AND LOW-COST EXTERNAL CAVITY LASER**

(71) Applicant: Nokia Solutions and Networks Oy, 02610 Espoo (FI)
(72) Inventor: BRENOT, Romain, 91767 PALAISEAU (FR); MAHO, Anaelle, 91767 PALAISEAU (FR)
(74) Representative: Novagraaf Technologies

(57) **Abstract**

The present invention relates to a transmitter and an optical network for high speed communication.

In particular, a transmitter for high speed data modulation comprising
- an external cavity laser adapted to generate a laser signal comprising a semiconductor optical amplifier to amplify the laser signal and at least a partial mirror; and
- an modulator adapted to modulate the laser signal,
the modulator is located outside of the laser cavity and is adapted to modulate the laser signal exiting the laser cavity through the partial mirror, and
wherein the semiconductor optical amplifier, the partial mirror and the modulator are integrated in a single chip.

Such architecture offers a cost-effective transmitter which can operate at high speed with a throughput of at least 10 Gbits and beyond.

## Description

### SPECIFICATION

### Field of the Invention

The present invention relates to a transmitter for high speed data modulation.

### Background

Telecommunications require higher and higher throughput and low costs facilities.

In Future Access systems (NG-PON2 and beyond), Time and Wavelength division multiplexed Passive Optical Networks (TWDM-PON) architectures aim at transmitting 10G or gigabits (and beyond) signals in the upstream direction (from the customer to the central station), while reaching a wide tunability (up to 20 nm) to increase the number of available channels, and thus the number of customers per system. This would lead to a significant decrease of the cost per customer.

Today, Distributed FeedBack (DFB) lasers and Electro-absorption Modulated Lasers (EML) are the only candidates for such tunable upstream transmitters. Their tunability is limited to 3 nm, and is achieved by thermal tuning.

Other widely tunable lasers can be obtained with complex devices (SG-DBR, DS-DBR, ...) or with External Cavity lasers. However, these lasers cannot be directly modulated at 10G, and the use of an external modulator is not cost effective. Cost is the main driver for access networks.

Thus, there is a need of a cost-effective transmitter which would combine wide tunability (above 3 nm) and high speed operation (10G and beyond).

### Summary

The present invention proposes transmitters for cost-effectively improve the speed of data modulation and so the throughput of optical networks to solve the prior art drawbacks.

In a first and general embodiment, the transmitter for high speed data modulation comprises:
- an external cavity laser adapted to generate a laser signal comprising a semiconductor optical amplifier to amplify the laser signal and at least a partial mirror; and
- a modulator adapted to modulate the laser signal,
wherein the modulator is located outside of the laser cavity and is adapted to modulate the laser signal exiting the laser cavity through the partial mirror, and wherein the partial mirror and the modulator are integrated, monolithically, in a single chip.

Advantageously, the partial mirror can be realized by:
- etching a trench in the chip; or
- photonic crystals; or
- high index contrast Bragg grating.

In order to have a widely tuned laser, the external cavity laser of the transmitter can further comprise:
- a tunable mirror adapted to form with the partial mirror the laser cavity; and
- optical switching means,
wherein the tunable mirror and the optical switching means are adapted to tune the laser signal according to multiple wavelengths.

Depending on the option, the tunable mirror can be:
- an optical Bragg grating; or
- tunable narrow-band mirrors adapted to form multiple laser cavities with the partial mirror and adapted to tune the laser signal according to multiple wavelengths.

Furthermore, to be compatible with Future Access System NG-PON2, so widely tunable:
- the tunability of the laser signal is preferably above 3 nm; and
- the modulator can be adapted to modulate the laser signal so that the transmitter has a throughput of at least 10 Gigabit Ethernet.

The present invention further relates to a New-Generation Passive Optical Network (NG-PON) for high speed communication comprising a transmitter as previously described.

### Brief Description of the Drawings

Some embodiments of devices in accordance with embodiments of the present invention are now described, by way of example only, and with reference to the accompanying drawings, in which :
- Figure 1 schematically illustrates a current transmitter for current optical networks;
- Figure 2 schematically illustrates a transmitter according to a first embodiment of the present invention; and
- Figure 3 schematically illustrates an optical network according to an embodiment of the present invention.

### Description of Embodiments

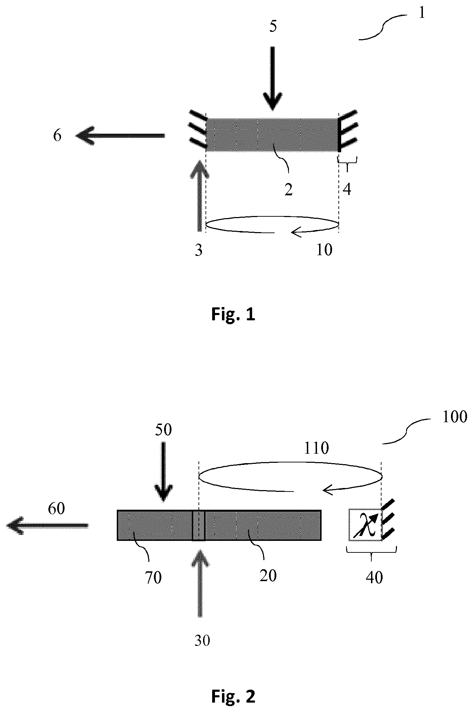

Figure 1 illustrates a current transmitter 1 for current optical networks. It comprises:
- a Reflective Semiconductor Optical Amplifier, RSOA, 2 which comprises a partial mirror 3;
- and a back mirror 4, both mirrors 3 and 4 forming a laser cavity 10.

The transmitter 1 generates an optical signal which is amplified and modulated by the RSOA 2 by direct modulation of the current 5 received by the RSOA 2. The partial mirror 3 lets the uploading optical signal 6 thus obtained pass and be transmitted into the optical network.

The RSOA 2 and the back mirror 4 can be realised monolithically or in two separated elements.

Such transmitter 1 can easily operate at 2.5 Gigabit Ethernet (Gbits) but their throughput is limited to 10 Gbits and they cannot go farther.

Figure 2 illustrates a first and general transmitter embodiment of the invention which solves the problem.

In this first and general embodiment, the transmitter 100 for high speed data modulation comprises:
- an external cavity laser 110 adapted to generate a laser signal and comprising a semiconductor optical amplifier, SOA 20, to amplify the laser signal and at least a partial mirror 30; and
- a modulator 70 adapted to modulate the laser signal.

The modulator 70 is located outside of the laser cavity 110 and is adapted to modulate the laser signal exiting the laser cavity through the partial mirror 30. The uploading optical signal 60 thus obtained can then be transmitted into the optical network.

Particularly, the SOA 20, the partial mirror 30 and the modulator 70 are integrated in a single chip. Such chip is cheap and easy to manufacture.

The modulator can be an Electro-Absorption Modulator, EAM, which can operate at 10Gbits and well above and at a moderate swing voltage 50. So the transmitter can have a throughput of at least 10 Gbits.

Advantageously, the partial mirror can be realized in different ways:
- by deep etching a trench in the chip;
- by photonic crystals; or
- by high index contrast Bragg grating.

In order to have a widely tunable laser, the external cavity laser further comprises:
- a tunable mirror 40 adapted to form with the partial mirror the laser cavity; and
- optical switching means (not represented),
the tunable mirror 40 and the optical switching means being adapted to tune the laser signal according to multiple wavelengths

The term "external laser cavity" comes from the fact that the laser cavity is realized by two distinctive elements (i.e. not monolithically integrated together): the chip comprising the partial mirror 30, or front mirror, and the tunable mirror 40, or back mirror.

Depending on the option, the tunable mirror can be an optical Bragg grating or tunable narrow-band mirrors adapted to form multiple laser cavities with the partial mirror and adapted to tune the laser signal according to multiple wavelengths.

Regarding the optical switching means, they can be realised by Micro-Opto-Electro-Mechanical Systems.

Such an architecture enables to have a laser tunable from 3 nm up to 20 nm and more, which increases the number of available channels and so the number of customers that can be linked to the optical network.

The present invention also relates to a New-Generation Passive Optical Network, NG-PON, for high speed communication comprising a transmitter as previously described.

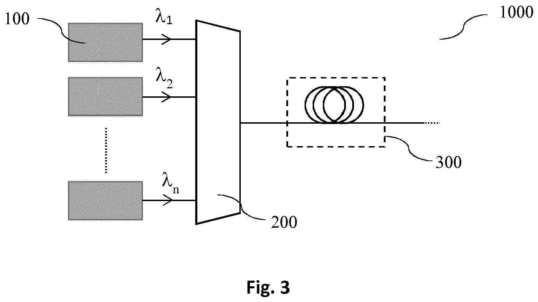

Figure 3 illustrates a NG-PON 1000 according to an embodiment of the invention.

The NG-PON 1000 comprises multiple transmitters 100, each emitting an upstream signal at one wavelength λᵢ, a Wavelength Division Multiplexing, WDM 200, and a Passive Optical Network, PON 300, such as an optical fiber. The outputs of the transmitters are linked to the WDM 200 which multiplexes all the signal and sends the multiplexed signal into the PON 300.

In such a NG-PON 1000, one transmitter 100 corresponds to a customer. The transmitter 100 being able to be tuned and operate at multiple wavelengths, it is possible for the transmitter 100 to change its operating wavelength, if necessary. For example in case of network overload, so that the customer has a constant and high throughput.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventors to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. A transmitter (100) for high speed data modulation comprising
- an external cavity laser (110) adapted to generate a laser signal comprising a semiconductor optical amplifier (20) to amplify the laser signal and at least a partial mirror (30); and
- a modulator (70) adapted to modulate the laser signal,
**characterized in that**
the modulator (70) is located outside of the laser cavity (110) and is adapted to modulate the laser signal exiting the laser cavity (110) through
the partial mirror (30), and
wherein the semiconductor optical amplifier (20), the partial mirror (30) and the modulator (70) are integrated in a single chip.

2. The transmitter (100) according to claim 1 wherein the partial mirror (30) is realized by deep etching a trench in the chip.

3. The transmitter (100) according to claim 1 wherein the partial mirror (30) is realized by photonic crystals.

4. The transmitter (100) according to claim 1 wherein the partial mirror (30) is realized by high index contrast Bragg grating.

5. The transmitter (100) according to one of the claims 1 to 4 wherein the external cavity laser (110) further comprises
- a tunable mirror (40) adapted to form with the partial mirror the laser cavity; and
- optical switching means,
the tunable mirror (40) and the optical switching means being adapted to tune the laser signal according to multiple wavelengths.

6. The transmitter (100) according to claim 5 wherein the tunable mirror (40) is an optical Bragg grating.

7. The transmitter (100) according to claim 5 wherein the tunable mirror (40) is tunable narrow-band mirrors adapted to form multiple laser cavities with the partial mirror and adapted to tune the laser signal according to multiple wavelengths.

8. The transmitter (100) according to one of claims 5 to 7 wherein the tunability of the laser signal is above 3 nm.

9. The transmitter (100) according to one of claims 1 to 8 wherein the modulator (70) is adapted to modulate the laser signal so that the transmitter (100) has a throughput of at least 10 Gigabit Ethernet.

10. A New-Generation Passive Optical Network for high speed communication comprising a transmitter (100) according to one of claims 1 to 9.
